# EUROPEAN PATENT APPLICATION

(11) **EP 4 471 873 A1**
(43) Date of publication of application: **04.12.2024**
(21) Application number: 24163352.8
(22) Date of filing: 13.03.2024
(51) Int. Cl.: H01L 29/775, H01L 21/336, H01L 29/06, H01L 29/08, H01L 29/165, H01L 29/423, B82Y 10/00

(54) **SEMICONDUCTOR DEVICE**

(30) Priority: 01.06.2023 KR 20230071091
(71) Applicant: Samsung Electronics Co., Ltd., Suwon-si, Gyeonggi-do 16677 (KR)
(72) Inventor: YOO, Hyumin, Suwon-si (KR); KANG, Myung Gil, Suwon-si (KR); KIM, Dongwon, Suwon-si (KR); KIM, Jongsu, Suwon-si (KR); NOH, Changwoo, Suwon-si (KR); PARK, Beomjin, Suwon-si (KR); JEONG, Soojin, Suwon-si (KR); CHOI, Woosuk, Suwon-si (KR)
(74) Representative: Marks & Clerk LLP

(57) **Abstract**

A semiconductor device is provided including an active pattern disposed on a substrate, a source/drain pattern on the active pattern, a channel pattern configured to electrically connect the source/drain patterns and including stacked semiconductor patterns spaced apart from each other in a first direction perpendicular to an upper surface of the substrate, a gate pattern configured to cross between the source/drain patterns in a second direction parallel to the upper surface of the substrate, on the channel pattern, and to have a main gate portion and sub-gate portions, and inner gate spacers between the sub-gate portions and the source/drain pattern. A first distance between adjacent source/drain patterns along a given one of the sub-gate portions in the second direction is greater than a second distance between adjacent source/drain patterns passing through the semiconductor patterns in the second direction.

## Description

### BACKGROUND

The present disclosure relates to a semiconductor device and a manufacturing method thereof.

Semiconductors are materials belonging to an intermediate class characterized as having properties of both a conductor and an insulator, and refer to a material that conducts electricity under certain conditions. Various semiconductor devices for example, memory devices may be manufactured using these semiconductor materials. Such semiconductor devices may be used in various electronic devices.

As the electronics industry develops to a high degree, demands on the characteristics of semiconductor devices are gradually increasing. For example, demands for high reliability, high speed, and/or multifunctionality of semiconductor devices are gradually increasing. In order to satisfy these required characteristics, structures within semiconductor devices are becoming increasingly complex and integrated.

### SUMMARY

One aspect of the present disclosure provides a semiconductor device that reduces leakage current while improving distribution during epitaxy (EPI) formation of source/drain patterns, improves channel resistance through a short channel length and high doping concentration on the channel side, and ensures uniform work function, thereby providing improved performance.

A semiconductor device according to one aspect includes an active pattern on a substrate, source/drain patterns on the active pattern, a channel pattern configured to electrically connect the source/drain patterns and including stacked semiconductor patterns spaced apart from each other in a first direction perpendicular to an upper surface of the substrate, a gate pattern configured to cross between the source/drain patterns in a second direction parallel to the upper surface of the substrate, on the channel pattern, and to have a main gate portion and sub-gate portions, and inner gate spacers having a first portion between the sub-gate portions and the source/drain patterns, and a second portion between the sub-gate portions and the semiconductor patterns. A first distance between adjacent source/drain patterns along a given one of the sub-gate portions in the second direction is greater than a second distance between adjacent source/drain patterns along a given one of the semiconductor patterns in the second direction.

A semiconductor device according to another aspect includes an active pattern on a substrate, source/drain patterns on the active pattern, a channel pattern configured to electrically connect the source/drain patterns and including stacked semiconductor patterns spaced apart from each other in a first direction perpendicular to an upper surface of the substrate; a gate pattern configured to cross between the source/drain patterns in a second direction parallel to the upper surface of the substrate, on the channel pattern, and to have a main gate portion and sub-gate portions, and inner gate spacers between the sub-gate portions and the source/drain patterns. A surface where the respective inner gate spacers are in contact with the source/drain patterns has a concave or flat shape toward the source/drain patterns, and a first distance between adjacent source/drain patterns along a given one of the sub-gate portions in the second direction is greater than a second distance between adjacent source/drain patterns along a given one of the semiconductor patterns in the second direction.

A semiconductor device according to another aspect includes an active pattern on a substrate, source/drain patterns on the active pattern, a channel pattern configured to electrically connect the source/drain patterns and including stacked semiconductor patterns spaced apart from each other in a first direction perpendicular to an upper surface of the substrate, a gate pattern configured to cross between the source/drain patterns in a second direction parallel to the upper surface of the substrate, on the channel pattern, and to have a main gate portion and sub-gate portions, and inner gate spacers having a first portion between the sub-gate portions and the source/drain patterns, and a second portion between the sub-gate portions and the channel pattern, wherein a surface where the respective inner gate spacers are in contact with the source/drain patterns has a concave or flat shape toward the source/drain patterns, a surface where the respective semiconductor patterns are in contact with the source/drain patterns has a concave shape toward the source/drain patterns, and a first distance between adjacent source/drain patterns along a given one of the sub-gate portions in the second direction is greater than a second distance between adjacent source/drain patterns along a given one of the semiconductor patterns in the second direction.

According to embodiments described herein, a first distance between adjacent source/drain patterns of the plurality of source/drain patterns along a given one of the sub-gate portions in the second direction is greater than a second distance between the adjacent source/drain patterns along a given one of the semiconductor patterns in the second direction. The first distance may be a distance measured along a first line that crosses through the one of the sub-gate portions in second direction. The second distance may be a distance measured along a second line that crosses through the given one of the semiconductor patterns in the second direction.

According to embodiments, a surface of each of the semiconductor patterns, where the semiconductor pattern is in contact with a corresponding one of the source/drain patterns, has a concave cross-sectional shape. That is, for each semiconductor pattern, a surface of the semiconductor pattern that faces a corresponding one of the source/drain patterns may have a concave shape. As described herein, a cross-sectional shape may be a shape when viewed in a cross-section taken along a plane defined by the first direction and second direction.

The source/drain patterns may each include a first source/drain pattern surrounding a second source/drain pattern, wherein a doping of the second source/drain pattern is greater than a doping concentration of the first source/drain pattern.

According to embodiments, by reducing leakage current, improving dispersion during epitaxial formation of source/drain patterns, improving channel resistance through a short channel length and high doping concentration on the channel side, and securing a uniform work function, it is possible to improve the performance of the semiconductor device.

At least some of the above and other features of the invention are set out in the claims.

### BRIEF DESCRIPTION OF THE DRAWINGS

FIG. 1 is a plan view illustrating at least a portion of an example semiconductor device according to an embodiment of the present disclosure.
FIG. 2 is a cross-sectional view depicting at least a portion of the example semiconductor device shown in FIG. 1, taken along line A-A' of FIG. 1.
FIG. 3 is a cross-sectional view depicting at least a portion of the example semiconductor device shown in FIG. 1, taken along line B-B' of FIG. 1.
FIG. 4 is an enlarged cross-sectional view illustrating an enlarged area P1 of FIG. 2.
FIG. 5 is a plan view corresponding to FIG. 2 illustrating an example semiconductor device according to an embodiment of the present disclosure.
FIG. 6 is a plan view corresponding to FIG. 2 illustrating an example semiconductor device according to an embodiment of the present disclosure.
FIG. 7 is a cross-sectional view illustrating an intermediate process step in an example method of manufacturing a semiconductor device according to an embodiment of the present disclosure.
FIG. 8 is a cross-sectional view illustrating an intermediate process step in an example method of manufacturing a semiconductor device according to an embodiment of the present disclosure.
FIG. 9 is a cross-sectional view illustrating an intermediate process step in an example method of manufacturing a semiconductor device according to an embodiment of the present disclosure.
FIG. 10 is a plan view corresponding to FIG. 9 illustrating an intermediate process step in an example method of manufacturing a semiconductor device according to an embodiment of the present disclosure.
FIG. 11 is a plan view corresponding to FIG. 9 illustrating an intermediate process step in an example method of manufacturing a semiconductor device according to an embodiment of the present disclosure.
FIG. 12 is a cross-sectional view illustrating an intermediate step of a method of manufacturing a semiconductor device according to an embodiment of the present disclosure.
FIG. 13 is a cross-sectional view illustrating an intermediate process step in an example method of manufacturing a semiconductor device according to an embodiment of the present disclosure.
FIG. 14 is a cross-sectional view illustrating an intermediate process step in an example method of manufacturing a semiconductor device according to an embodiment of the present disclosure.
FIG. 15 is a cross-sectional view illustrating an intermediate process step in an example method of manufacturing a semiconductor device according to an embodiment of the present disclosure.
FIG. 16 is a cross-sectional view illustrating an intermediate process step in an example method of manufacturing a semiconductor device according to an embodiment of the present disclosure.

### DETAILED DESCRIPTION

The present invention will be described more fully hereinafter with reference to the accompanying drawings, in which embodiments of the invention are shown. As those skilled in the art would realize, the described embodiments may be modified in various different ways, all without departing from the spirit or scope of the present invention.

The drawings and description are to be regarded as illustrative in nature and not restrictive. Like reference numerals designate like elements throughout the specification and several views of the drawings.

The size and thickness of each constituent element as shown in the drawings are randomly indicated for better understanding and ease of description, and this disclosure is not necessarily limited to the arrangements as shown. In the drawings, the thickness of layers, regions, etc., may be exaggerated for clarity. In addition, in the drawings, for better understanding and ease of description, the thickness of some layers and areas may be exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational (i.e., vertical) direction.

In addition, unless explicitly described to the contrary, the word "comprise", and variations such as "comprises" or "comprising", will be understood to imply the inclusion of stated elements but not the exclusion of any other elements.

In addition, in this specification, the phrase "on a plane" means viewing a target portion from the top, and the phrase "on a cross-section" means viewing a cross-section formed by vertically cutting a target portion from the side. As described herein, a surface having a cross-sectional shape "toward" a particular feature may refer to a shape of the surface facing toward the feature when viewed along a cross-section formed by vertically cutting a target portion from the side.

In the drawings of a semiconductor device according to one or more embodiments, a transistor including nanowires or nanosheets, a multi-bridge channel field effect transistor (MBCFETTM), and a fin-type transistor including a fin-type pattern-shaped channel region (FinFET) are illustrated, but the present disclosure is not limited thereto. For example, a semiconductor device according to some embodiments may include a tunneling transistor (tunneling FET), a three-dimensional (3D) stack field effect transistor (3DSFET), or a complementary field effect transistor (CFET).

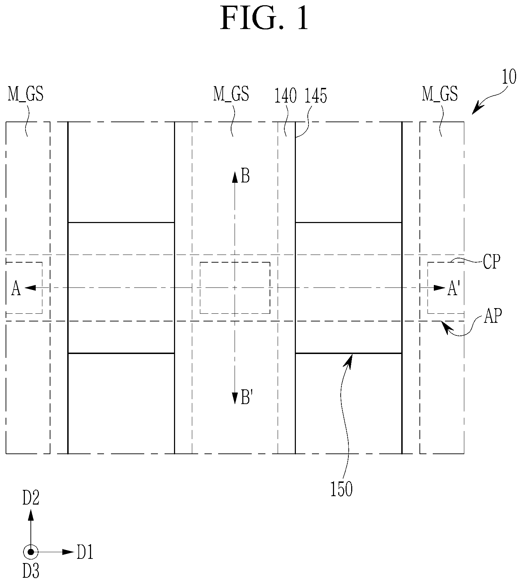

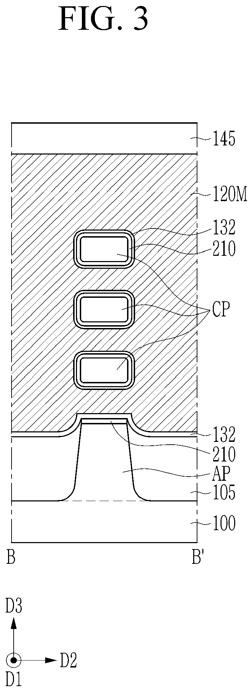

Referring to FIGS. 1 to 4, a semiconductor device 10 according to an embodiment includes a substrate 100, an active pattern AP on the substrate 100, and a source/drain pattern 150 on the active pattern AP, a channel pattern CP between the source/drain patterns 150, and a gate pattern GS configured to cross the source/drain patterns 150 and to surround the channel pattern CP. The term "surround" (or "surrounding," or like terms) as may be used herein is intended to broadly refer to an element, structure or layer that extends around, envelops, encircles, or encloses another element, structure or layer on all sides, although breaks or gaps may also be present. Thus, for example, a material layer having voids therein may still "surround" another layer which it encircles.

Optionally, the semiconductor device 10 may further include a gate spacer 140, a capping layer 145, an etch stop layer 185, and an interlayer insulating layer 190.

The substrate 100 may include bulk silicon or silicon-on-insulator (SOI). Alternatively, the substrate 100 may include a silicon substrate, or other materials such as silicon germanium (SiGe), silicon germanium on insulator (SGOI), indium antimonide, lead tellurium compound, indium arsenide, indium phosphide, gallium arsenide, or gallium antimonide.

The upper surface of the substrate 100 may be formed as a plane parallel to a first direction (D1 direction) and a second direction (D2 direction) crossing the first direction (D1 direction). The first direction D1 and second direction D2 may be perpendicular to each other. The first direction D1 and second direction D2 may define a horizontal plane for the semiconductor device 10.

The substrate 100 may include a trench defining the active patterns AP, and a field insulating layer 105 may be disposed in the trench (e.g., at least partially filling the trench).

The active pattern AP may have a sheet or fin shape. The active patterns AP may extend along the first direction (D1 direction) and may be spaced apart from each other along the second direction (D2 direction).

For example, the active pattern AP may be disposed in an area where an n-channel metal-oxide-semiconductor (NMOS) device is formed. As another example, the active pattern AP may be disposed in a region where a p-channel metal-oxide-semiconductor (PMOS) device is formed.

The active pattern AP may be formed by etching a portion of the substrate 100 or may include an epitaxial layer grown from the substrate 100. The active pattern AP may include an elemental semiconductor material (i.e., composed of a single species of atoms) such as silicon (Si) or germanium (Ge). Also, the active pattern AP may include a compound semiconductor, for example, a Group IV-IV compound semiconductor or a Group III-V compound semiconductor.

The Group IV-IV compound semiconductor may be, for example, a binary compound or ternary compound including at least two of carbon (C), silicon (Si), germanium (Ge), and tin (Sn).

The Group III-V compound semiconductor may be, for example, one of a binary compound, a ternary compound, or a quaternary compound formed by combining at least one of aluminum (Al), gallium (Ga), and indium (In) as a Group III element and one of phosphorus (P), arsenic (As), and antimony (Sb) as a Group V element.

The field insulating layer 105 may be disposed on the substrate 100. The field insulating layer 105 may be disposed to fill the trench. The term "fill" (or "filling," or like terms) as may be used herein is intended to refer broadly to either completely filling a defined space (e.g., trench) or partially filling the defined space; that is, the defined space need not be entirely filled but may, for example, be partially filled or have voids or other spaces throughout.

For example, the field insulating layer 105 may be disposed on a sidewall of the active pattern AP. The field insulating layer 105 is not disposed on the upper surface of the active pattern AP. The field insulating layer 105 may entirely cover side surfaces of the active pattern AP. In this case, a portion of the active pattern AP may protrude from the upper surface of the field insulating layer 105 in a third direction (D3 direction). Alternatively, the field insulating layer 105 may cover a portion of the sidewall of the active pattern AP. The term "cover" (or "covering," or like terms) as may be used herein is intended to broadly refer to a material, layer or structure being on or over another material, layer or structure, but does not require the material, layer or structure to *entirely* cover the other material, layer or structure.

The field insulating layer 105 may include an insulating material, and may include, for example, oxide, nitride, oxynitride, or a combination thereof. Although the field insulating layer 105 is shown as a single layer, it is only for convenience of explanation, and the present disclosure is not limited thereto; for example, in some embodiments, the field insulating layer 105 may include multiple layers of insulating material.

The channel pattern CP may be disposed on the active pattern AP. The channel pattern CP may be spaced apart from the active pattern AP in a third direction (D3 direction). Here, the third direction (D3 direction) may be a direction crossing (i.e., perpendicular to) the first direction (D1 direction) and the second direction (D2 direction). For example, the third direction (D3 direction) may be a cross-sectional thickness direction of the substrate 100. The third direction D3 may define a vertical direction for the semiconductor device 10. The third direction D3 may define a height direction for the semiconductor device 10. Features that are further along the third direction D3 (e.g. further from the substrate 100, along the third direction D3) may be considered higher than, or above, other features that are less far along the third direction D3 (e.g. closer to the substrate 100, along the third direction D3).

The channel pattern CP may include semiconductor patterns SP1, SP2, and SP3. For example, the channel pattern CP may include a first semiconductor pattern SP1, a second semiconductor pattern SP2, and a third semiconductor pattern SP3. The first semiconductor pattern SP1, the second semiconductor pattern SP2, and the third semiconductor pattern SP3 may be disposed higher than the upper surface of the field insulating layer 105, in the third direction D3, relative to the upper surface of the substrate 100.

A second semiconductor pattern SP2 may be disposed on the first semiconductor pattern SP1, and the third semiconductor pattern SP3 may be disposed on the second semiconductor pattern SP2; that is, the semiconductor patterns SP1, SP2 and SP3 may be stacked sequentially on each other in the third direction D3. The second semiconductor pattern SP2 is spaced apart from the first semiconductor pattern SP1 and the third semiconductor pattern SP3 in the third direction (D3 direction). Each separation distance between the semiconductor patterns SP1, SP2, and SP3 may be substantially the same. However, the present disclosure is not limited thereto, and the separation distance between the semiconductor patterns SP1, SP2, and SP3 may be different.

The semiconductor patterns SP1, SP2, and SP3 may have substantially the same cross-sectional thickness, but are not limited thereto, and at least one of the semiconductor patterns SP1, SP2, and SP3 may have a different cross-sectional thickness.

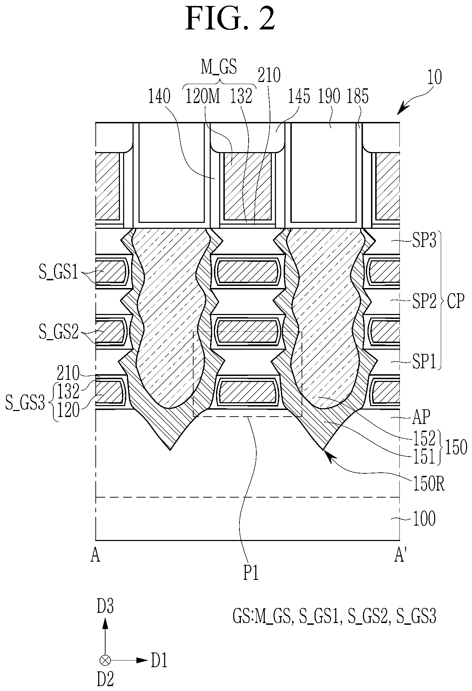

In FIG. 2, three semiconductor patterns SP1, SP2, and SP3 are illustrated as being spaced apart from each other and stacked along the third direction (D3 direction), but this is for convenience of explanation only, and the present disclosure is not limited thereto. For example, four or more semiconductor patterns may be spaced apart from each other along the third direction (D3 direction) and stacked.

The semiconductor patterns SP1, SP2, and SP3 may include one of elemental semiconductor materials such as silicon (Si) or silicon germanium (SiGe), a Group IV-IV compound semiconductor, or a Group III-V compound semiconductor. Each of the semiconductor patterns SP1, SP2, and SP3 may include the same material as the active pattern AP or a material different from that of the active pattern AP.

The gate pattern GS may be disposed on the substrate 100. The gate pattern GS may extend in the second direction (D2 direction). The gate patterns GS may be spaced apart from each other in the first direction (D1 direction).

For example, the gate pattern GS may be disposed on the active pattern AP and may cross the active pattern AP. A lower portion of the gate pattern GS may cross an upper portion of the active pattern AP. The gate pattern GS may surround (i.e., extend around) each of the semiconductor patterns SP1, SP2, and SP3.

The gate pattern GS may include sub-gate portions S_GS1, S_GS2, and S_GS3 and a main gate portion M_GS. The sub-gate portions S_GS1, S_GS2, and S_GS3 may be disposed between the adjacent semiconductor patterns SP1, SP2, and SP3 in the third direction (D3 direction) and between the active pattern AP and the semiconductor patterns SP1, SP2, and SP3. The main gate portion M_GS may be disposed on the semiconductor patterns SP1, SP2, and SP3 at the uppermost portion in the third direction (D3 direction) and between the semiconductor patterns SP1, SP2, and SP3 spaced apart from each other in the second direction (D2 direction).

As the channel pattern CP includes a plurality of semiconductor patterns SP1, SP2, and SP3, the gate pattern GS may include a plurality of sub-gate portions S_GS1, S_GS2, and S_GS3. The number of sub-gate portions S_GS1, S_GS2, and S_GS3 may be proportional to the number of the semiconductor patterns SP1, SP2, and SP3 included in the channel pattern CP. For example, the number of sub-gate portions S_GS1, S_GS2, and S_GS3 may be the same as the number of the semiconductor patterns SP1, SP2, and SP3.

The sub-gate portions S_GS1, S_GS2, and S_GS3 may include a first sub-gate portion S_GS1, a second sub-gate portion S_GS2, and a third sub-gate portion S_GS3. The third sub-gate portion S_GS3, the second sub-gate portion S_GS2, and the first sub-gate portion S_GS1 may be sequentially spaced apart from each other and stacked on the active pattern AP in the third direction (D3 direction). Hereinafter, a case in which the number of sub-gate portions S_GS1, S_GS2, and S_GS3 is three will be described. However, the present disclosure is not limited thereto, and may include two sub-gate portions, or four or more sub-gate portions.

For example, the third sub-gate portion S_GS3 may be disposed between the upper surface of the active pattern AP and the lower surface of the first semiconductor pattern SP1, the second sub-gate portion S_GS2 may be disposed between the upper surface of the active pattern AP and the lower surface of the first semiconductor pattern SP1, and the first sub-gate portion S_GS1 may be disposed between the upper surface of the second semiconductor pattern SP2 and the lower surface of the third semiconductor pattern SP3.

The sub-gate portions S_GS1, S_GS2, and S_GS3 may be disposed between source/drain patterns 150 to be described later. In this case, an inner gate spacer 210 may be disposed between the sub-gate portions S_GS1, S_GS2, and S_GS3 and the source/drain pattern 150.

Each of the sub-gate portions S_GS1, S_GS2, and S_GS3 may include a sub-gate electrode 120 and a gate insulating layer 132.

The sub-gate electrode 120 may include a metal, a metal alloy, a conductive metal nitride, a metal silicide, a doped semiconductor material, a conductive metal oxide, or a conductive metal oxynitride. The sub-gate electrode 120 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The conductive metal oxide and the conductive metal oxynitride may include an oxidized form of the above material, but are not limited thereto.

In this case, the inner gate spacer 210 is disposed between the sub-gate portions S_GS1, S_GS2, and S_GS3 and the source/drain pattern 150. The inner gate spacer 210 is described below. The inner gate spacer 210 is described with references to the sub-gate portions S_GS1, S_GS2, and S_GS3; however, it will be appreciated that the inner gate spacer 210 may be multiple inner gate spacers 210, each surrounding a corresponding one of the sub-gate portions S_GS1, S_GS2, and S_GS3. Where features of the inner gate spacer 210 are described with reference to the sub-gate portions S_GS1, S_GS2, and S_GS3, this may be with reference to the corresponding one of the sub-gate portions the sub-gate portions S_GS1, S_GS2, and S_GS3 that the inner gate spacer 210 surrounds. Similarly, where features of the inner gate spacer 210 are described, this describe an individual one of the inner gate spacers 210.

The inner gate spacer 210 may include a low dielectric constant (low-k) material. The low dielectric constant material may include silicon oxide or a material having a lower dielectric constant than silicon oxide. For example, the low dielectric constant material may include silicon oxide, silicon oxide doped with fluorine or carbon, porous silicon oxide, or an organic polymeric dielectric. However, it is not limited thereto, and the inner gate spacer 210 may include, for example, silicon nitride (SiN), silicon oxynitride (SiON), silicon oxide (SiO₂), silicon oxycarbonitride (SiOCN), silicon boron nitride (SiBN), silicon oxyboronitride (SiOBN), silicon oxycarbide (SiOC), or a combination thereof.

For example, the inner gate spacer 210 may have a first portion 211 disposed between the sub-gate portions S_GS1, S_GS2, and S_GS3 and the source/drain pattern 150, and a second portion 212 disposed between the sub-gate portions S_GS1, S_GS2, and S_GS3 and the semiconductor patterns SP1, SP2, and SP3. In addition, the inner gate spacer 210 may have a third portion 213 disposed between the sub-gate portions S_GS1, S_GS2, and S_GS3 and the active pattern AP.

However, the present disclosure is not limited thereto, and the inner gate spacer 210 may have the first portion 211 alone and may not have the second portion 212 or the third portion 213. That is, the inner gate spacer 210 may be disposed between the sub-gate portions S_GS1, S_GS2, and S_GS3 and the source/drain pattern 150 alone, and may not be disposed between the sub-gate portions S_GS1, S_GS2, and S_GS3 and the semiconductor patterns SP1, SP2 and SP3 or between the sub-gate portions S_GS1, S_GS2 and S_GS3 and the active pattern AP.

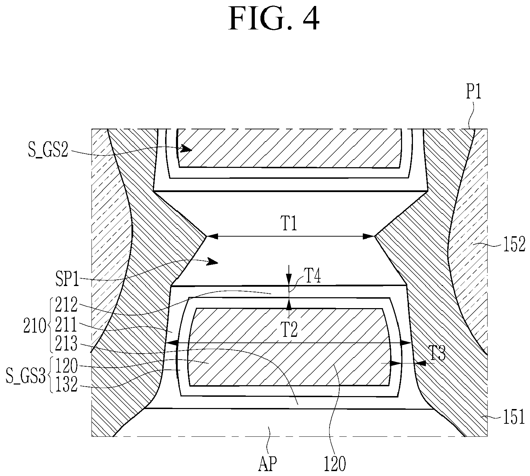

The first portion 211 and the second portion 212 of the inner gate spacer 210 may be connected to each other to surround the sub-gate portions S_GS1, S_GS2, and S_GS3 (when viewed in cross section). For example, surfaces of the sub-gate portions S_GS1, S_GS2, and S_GS3 that are not connected to the main gate portion M_GS, for example, four surfaces (e.g. a top surface, a bottom surface, and two side surfaces), may be surrounded by the inner gate spacer 210. As shown in FIG. 4, the sub-gate portions S_GS1, S_GS2, and S_GS3 may be surrounded by the inner gate spacer 210 in a cross-sectional plane parallel to the first and second directions D1 and D2.

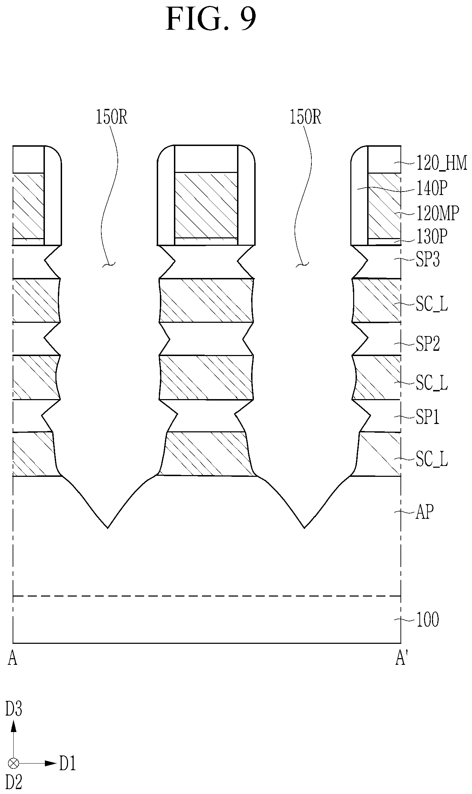

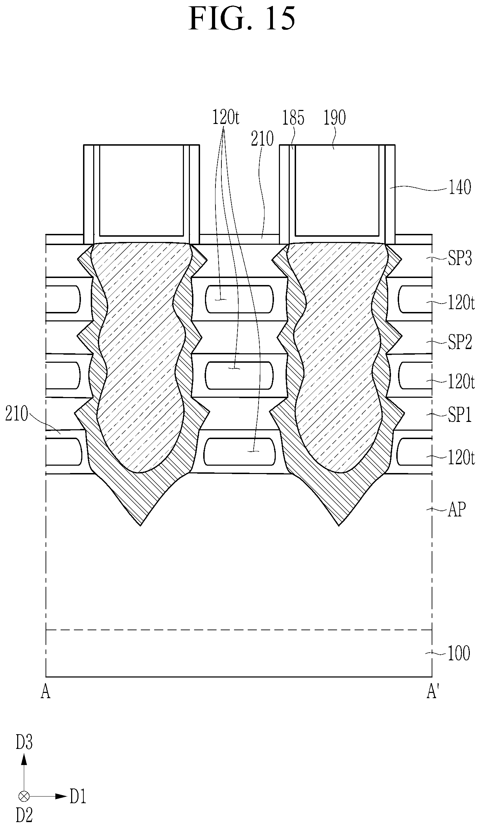

As shown in FIG. 9, described in further detail later, in a method of manufacturing the semiconductor device 10 according to an embodiment, after forming a source/drain recess 150R and before forming the source/drain pattern 150 inside the source/drain recess 150R, instead of forming the inner gate spacer 210, as shown in FIG. 15, after removing the sacrificial layer SC_L and before forming the sub-gate electrode 120, the inner gate spacer 210 is formed, and thereby the inner gate spacer 210 may have a first portion 211 disposed between the sub-gate portions S_GS1, S_GS2, and S_GS3 and the source/drain pattern 150, a second portion 212 disposed between the sub-gate portions S_GS1, S_GS2, and S_GS3 and the semiconductor patterns SP1, SP2, and SP3, and optionally a third portion 213 disposed between the sub-gate portions S_GS1, S_GS2, and S_GS3 and the active pattern AP.

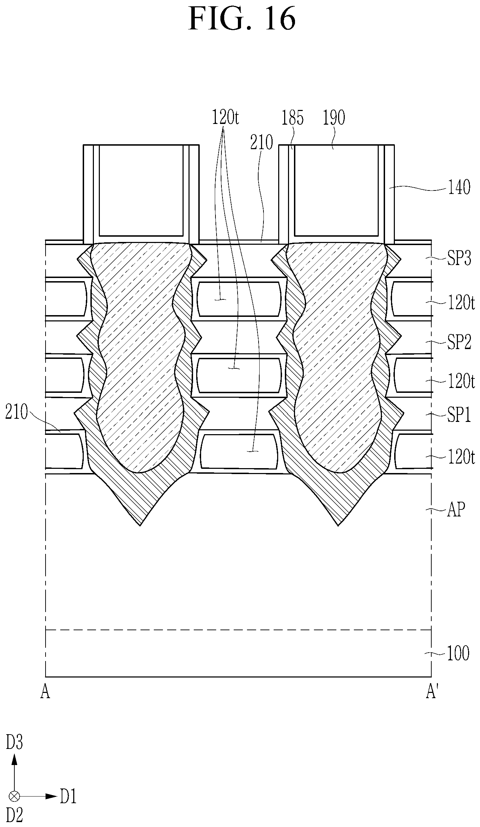

In addition, as shown in FIGS. 15 and 16 to be described in further detail later, after forming the inner gate spacer 210, the thickness of the inner gate spacer 210 may be reduced through an etching process, thereby securing a sufficient space for forming the sub-gate electrode 120. Accordingly, the thickness of the first portion 211 of the inner gate spacer 210 may be greater than the thickness of the second portion 212 of the inner gate spacer 210.

Here, the thickness T3 of the first portion 211 of the inner gate spacer 210 may mean a minimum thickness of the first portion 211 of the inner gate spacer 210 in the first direction (D1 direction). For example, the thickness T3 of the first portion 211 of the inner gate spacer 210 may mean the shortest distance between the sub-gate portions S_GS1, S_GS2, and S_GS3 and the source/drain pattern 150 in the first direction (D1 direction). The thickness T4 of the second portion 212 of the inner gate spacer 210 may mean a minimum thickness of the second portion 212 of the inner gate spacer 210 in the third direction (D3 direction). For example, the thickness T4 of the second portion 212 of the inner gate spacer 210 may mean the shortest distance between the sub-gate portions S_GS1, S_GS2, and S_GS3 and the semiconductor patterns SP1, SP2, and SP3 in the third direction (D3 direction).

For example, the thickness T3 of the first portion 211 and the thickness T4 of the second portion 212 of the inner gate spacer 210 may be measured by observing by a scanning electron microscope (SEM) or a scanning transmission electron microscope (STEM) on a cross section (i.e., FIG. 2) cut parallel to the first direction (D1 direction) and the third direction (D3 direction) at the middle point (1/2 point) of the second direction (D2 direction) of a certain semiconductor pattern SP1, SP2, or SP3.

For example, a ratio of the thickness T3 of the first portion 211 of the inner gate spacer 210 to the thickness T4 of the second portion 212 may be in a range of greater than about 1:0 (e.g. greater than 1:0) and less than about 1:1 (e.g. less than 1:1), less than about 1:0.9 (e.g. less than 1:0.9), less than about 1:0.8 (e.g. less than 1:0.8), less than about 1:0.7 (e.g. less than 1:0.7), less than about 1:0.6 (e.g. less than 1:0.6), less than about 1:0.5 (e.g. less than 1:0.5), less than about 1:0.4 (e.g. less than 1:0.4), less than about 1:0.3 (e.g. less than 1:0.3), less than about 1:0.2 (e.g. less than 1:0.2), or less than about 1:0.1 (e.g. less than 1:0.2).

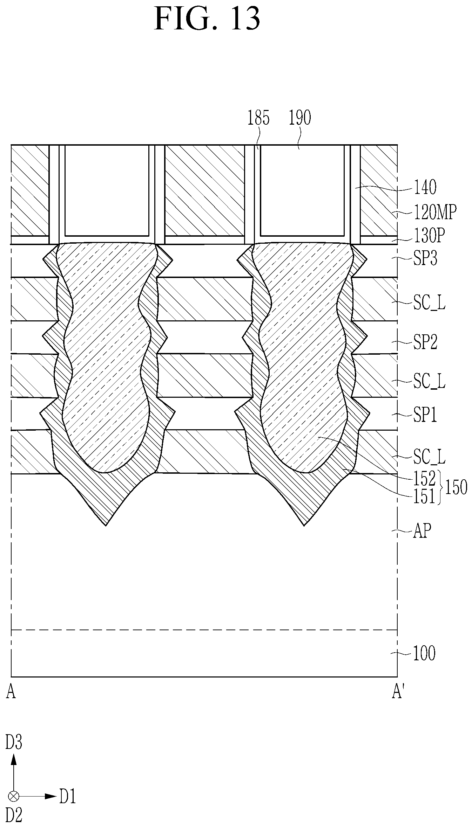

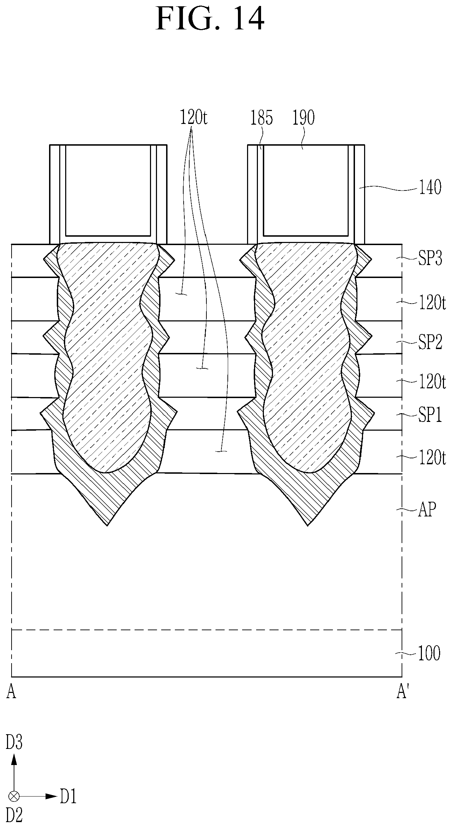

Also, a surface (e.g. a first surface) where the inner gate spacer 210 is in contact with the sub-gate electrode 120 may have a substantially concave or flat shape toward the sub-gate electrode 120. This is because the inner gate spacer 210 is formed in a gate trench 120t (see, e.g., FIG. 14) from which a sacrificial layer SC_L (see, e.g., FIG. 13) is removed.

A first surface may be a surface of the first portion 211 of the inner gate spacer 210 that is in contact with the sub-gate portions S_GS1, S_GS2, and S_GS3 in the first direction (D1 direction). The first distance from a central axis of the sub-gate portions S_GS1, S_GS2, and S_GS3 to the first surface (e.g. at an upper or lower portion of the sub-gate portions S_GS1, S_GS2, and S_GS3) may be smaller than a second distance from a central axis of the sub-gate portions S_GS1, S_GS2, and S_GS3 to the first surface (e.g. at a midpoint (1/2 point) between the upper and lower surfaces of the inner gate spacer 210). The central axis of the sub-gate portions S_GS1, S_GS2, and S_GS3 may be a line segment parallel to the third direction (D3 direction) while bisecting the sub-gate portions S_GS1, S_GS2, and S_GS3 in the first direction (D1 direction). Accordingly, the first surface of the first portion 211 of the inner gate spacer 210 may be concave, in that a central portion of the first surface is recessed.

Herein, the first distance and the second distance may be measured by observing by a scanning electron microscope (SEM) or a scanning transmission electron microscope (STEM) on a cross section (i.e., FIG. 2) cut parallel to the first direction (D1 direction) and the third direction (D3 direction) at the middle point (1/2 point) of the second direction (D2 direction) of any one of gate pattern GS.

The first distance may be the distance from the central axis of the sub-gate portions S_GS1, S_GS2, and S_GS3 to the first surface measured at the upper or lower surface of the inner gate spacer 210. The upper surface of the inner gate spacer 210 may be a surface in contact with an upper surface of one of the sub-gate portions S_GS1, S_GS2, and S_GS3. The lower surface of the inner gate spacer 210 may be a surface in contact with a lower surface of one of the sub-gate portions S_GS1, S_GS2, and S_GS3. In addition, as the distance from the central axis of the sub-gate portions S_GS1, S_GS2, and S_GS3 to the first surface, a distance measured from the midpoint (1/2 point) between the upper and lower surfaces of the inner gate spacer 210 may be a second distance.

The first distance and the second distance may be distances measured along the first direction (D1 direction) from the central axis of the sub-gate portions S_GS1, S_GS2, and S_GS3 to the first surface, respectively. For example, the first distance may be a distance measured from the upper surface of the sub-gate portions S_GS1, S_GS2, and S_GS3, and may be the shortest distance among the distances from the central axis of the sub-gate portions S_GS1, S_GS2, and S_GS3 to the first surface. In addition, the second distance may be a distance measured on a plane bisecting the sub-gate portions S_GS1, S_GS2, and S_GS3 in the third direction (D3 direction).

As shown in FIG. 4, the distance from the central axis of the sub-gate portions S_GS1, S_GS2, and S_GS3 to the first surface may increase as the distance from the active pattern AP in the third direction (D3 direction) increases, and then, it may decrease after passing approximately the midpoint of the sub-gate portions S_GS1, S_GS2, and S_GS3.

Also, a surface (e.g. a second surface) where the inner gate spacer 210 is in contact with the source/drain pattern 150 may have a substantially concave or flat shape toward the source/drain pattern 150. For example, a third distance from the central axis of the sub-gate portions S_GS1, S_GS2, and S_GS3 to a second surface (e.g. at an upper or lower portion of the sub-gate portions S_GS1, S_GS2, and S_GS3) may be greater than a fourth distance from a central axis of the sub-gate portions S_GS1, S_GS2, and S_GS3 to the second surface (e.g. at a midpoint (1/2 point) between the upper and lower surfaces of the inner gate spacer 210). For example, the second surface may refer to a surface where the first portion 211 of the inner gate spacer 210 is in contact with the source/drain pattern 150. Alternatively, the second surface may refer to an outermost surface of the inner gate spacer 210 in the first direction (D1 direction).

Herein, the third distance and the fourth distance may be measured by observing by a scanning electron microscope (SEM) or a scanning transmission electron microscope (STEM) on a cross section (i.e., FIG. 2) cut parallel to the first direction (D1 direction) and the third direction (D3 direction) at the middle point (1/2 point) of the second direction (D2 direction) of any one of the sub-gate portion S_GS1, S_GS2, and S_GS3.

The third distance may be the distance from the central axis of the sub-gate portions S_GS1, S_GS2, and S_GS3 to the second surface, measured at the upper or lower surface of the inner gate spacer 210. In addition, the fourth distance may be the distance from the central axis of the sub-gate portions S_GS1, S_GS2, and S_GS3 to the second surface, measured at the midpoint (1/2 point) between the upper and lower surfaces of the inner gate spacer 210. Accordingly, the second surface of the first portion 211 of the inner gate spacer 210 may be concave, in that a central portion of the second surface is recessed.

The third distance and the fourth distance may be distances measured along the first direction (D1 direction) from the central axis of the sub-gate portions S_GS1, S_GS2, and S_GS3 to the second surface, respectively. For example, the third distance may be a distance measured from the upper surface of the inner gate spacer 210. In addition, the fourth distance may be a distance measured on a plane bisecting the sub-gate portions S_GS1, S_GS2, and S_GS3 in the third direction (D3 direction), and may be the shortest distance among the distances from the central axis of the sub-gate portions S_GS1, S_GS2, and S_GS3 to the second surface.

As shown in FIG. 4, the distance from the central axis of the sub-gate portions S_GS1, S_GS2, and S_GS3 to the second surface may decrease as the distance from the active pattern AP in the third direction (D3 direction) increases, and then it may increase after passing approximately the midpoint.

For example, the thickness of the first portion 211 of the inner gate spacer 210 in the first direction (D1 direction) may decrease and then increase again as it goes from the upper portion to the lower portion of the first portion 211 of the inner gate spacer 210. That is, the upper and lower thicknesses of the first portion 211 may be greater than the thickness of the center portion of the first portion 211 in the third direction (D3 direction).

The shape of the semiconductor patterns SP1, SP2, and SP3 shall now be described. It will be appreciated that, whilst the shape of the semiconductor patterns SP1, SP2, and SP3 is mutually described, as each of the semiconductor patterns SP1, SP2, and SP3 has a similar shape, this description applies individually to each of the semiconductor patterns SP1, SP2, and SP3. Surfaces (e.g. third surfaces) of the semiconductor patterns SP1, SP2, and SP3 that contact the source/drain pattern 150 may have a concave shape toward the source/drain pattern 150. For example, a fifth distance from the central axis of the semiconductor patterns SP1, SP2, and SP3 to a third surface (e.g. at an upper or lower portion of the semiconductor patterns SP1, SP2, and SP3) may be smaller than the sixth distance from a central axis of the semiconductor patterns SP1, SP2, and SP3 to the second surface (e.g. at a midpoint (1/2 point) between the upper and lower surfaces of the semiconductor patterns SP1, SP2, and SP3). A central axis of the semiconductor patterns SP1, SP2, and SP3 may be a line segment parallel to a third direction (D3 direction) while bisecting the semiconductor patterns SP1, SP2, and SP3 in the first direction (D1 direction). For example, the third surface may refer to a surface where (one or each of) the semiconductor patterns SP1, SP2, and SP3 contact the source/drain pattern 150 in the first direction (D1 direction). Alternatively, the third surface may refer to an outermost surface of the semiconductor patterns SP1, SP2, and SP3 in the first direction (D1 direction).

Herein, the fifth distance and the sixth distance may be measured by observing by a scanning electron microscope (SEM) or a scanning transmission electron microscope (STEM) on a cross section (i.e., FIG. 2) cut parallel to the first direction (D1 direction) and the third direction (D3 direction) at the middle point (1/2 point) of the second direction (D2 direction) of any one of gate pattern GS.

The fifth distance may be a distance from the central axis of the semiconductor patterns SP1, SP2, and SP3 to the third surface, measured from an upper surface or a lower surface of the semiconductor patterns SP1, SP2, and SP3. In addition, the sixth distance may be the distance from the central axis of the semiconductor patterns SP1, SP2, and SP3 to the third surface, measured at the midpoint (1/2 point) between the upper and lower surfaces of the semiconductor patterns SP1, SP2, and SP3.

The fifth distance and the sixth distance may be distances measured along the first direction (D1 direction) from the central axis of the semiconductor patterns SP1, SP2, and SP3 to the third surface, respectively. For example, the fifth distance may be a distance measured from the upper surface of the semiconductor patterns SP1, SP2, and SP3. In addition, the sixth distance may be a distance measured on a plane that halves the semiconductor patterns SP1, SP2, and SP3 in the third direction (D3 direction), and may be the shortest distance among the distances from the central axis of the semiconductor patterns SP1, SP2, and SP3 to the third surface.

As shown in FIG. 4, the distance from the central axis of the semiconductor patterns SP1, SP2, and SP3 to the third surface may decrease as the distance from the surface contacting the sub-gate portions S_GS1, S_GS2, and S_GS3 in the third direction (D3 direction), and then it may increase after passing approximately the midpoint.

For example, a concave cross-sectional shape of a surface where the semiconductor patterns SP1, SP2, and SP3 are in contact with the source/drain pattern 150 may have a deeper and sharper (i.e., more pointed) shape than a concave cross-sectional shape of a surface where the inner gate spacer 210 is in contact with the source/drain pattern 150, as shown in FIG. 9 described later, by an indent process for the semiconductor patterns SP1, SP2, and SP3. For example, the concave cross-sectional shape of a surface where the semiconductor patterns SP1, SP2, and SP3 are in contact with the source/drain pattern 150 may be a semi-circular or round, half-ellipse (i.e., semiellipse), triangular, sigma or partial sigma, rectangular or box-shaped, polygon, or a combination thereof.

In the semiconductor device 10 according to an embodiment, a distance T2 between adjacent source/drain patterns 150 passing through the sub-gate portions S_GS1, S_GS2, and S_GS3 (e.g. along an axis or axes passing through one or each of the sub-gate portions S_GS1, S_GS2, and S_GS3) in the first direction D1 may be greater than a distance T1 between adjacent source/drain patterns 150 passing through the semiconductor patterns SP1, SP2, and SP3 (e.g. along an axis or axes passing through one or each of the semiconductor patterns SP1, SP2, and SP3) in the first direction D1.

At this time, the distance T2 between the adjacent source/drain patterns 150 passing through the sub-gate portions S_GS1, S_GS2, and S_GS3 may mean the shortest distance among distances between adjacent source/drain patterns 150 passing through the sub-gate portions S_GS1, S_GS2, and S_GS3 in the first direction D1, and the distance T1 between the adjacent source/drain patterns 150 passing through the semiconductor patterns SP1, SP2, and SP3 may mean the shortest distance among distances between the adjacent source/drain patterns 150 passing through the semiconductor patterns SP1, SP2, and SP3 in the first direction D1.

Hereinafter, the distance T2 between adjacent source/drain patterns 150 passing through the sub-gate portions S_GS1, S_GS2, and S_GS3 is referred to as the distance T2 across the sub-gate portions S_GS1, S_GS2, and S_GS3, and the distance T1 between adjacent source/drain patterns 150 passing through the semiconductor patterns SP1, SP2, and SP3 is referred to as the distance T1 across the semiconductor patterns SP1, SP2, and SP3.

For example, the distance T2 across the sub-gate portions S_GS1, S_GS2, and S_GS3 and the distance T1 across the semiconductor patterns SP1, SP2, and SP3 may be measured by observing by a scanning electron microscope (SEM) or a scanning transmission electron microscope (STEM) on a cross section (i.e., FIG. 2) cut parallel to the first direction (D1 direction) and the third direction (D3 direction) at the midpoint (1/2 point) of the second direction (D2 direction) of any one of the source/drain pattern 150

When measuring the distance T2 across the sub-gate portions S_GS1, S_GS2, and S_GS3 and the distance T1 across the semiconductor patterns SP1, SP2, and SP3, the sub-gate portions S_GS1, S_GS2, and S_GS3 and the semiconductor patterns SP1, SP2, and SP3 may be disposed adjacent to each other in the third direction D3. For example, the distance T2 across the third sub-gate portion S_GS3 may be greater than the distance T1 across the first semiconductor pattern SP1, the distance T2 across the second sub-gate portion S_GS2 may be greater than a distance T1 across the second semiconductor pattern SP2, and the distance T2 across the first sub-gate portion S_GS1 may be greater than a distance T1 across the third semiconductor pattern SP3.

As shown in FIG. 4, the distance T2 across the sub-gate portions S_GS1, S_GS2, and S_GS3 may be a sum of the lengths of the sub-gate portions S_GS1, S_GS2, and S_GS3 in the first direction (D1 direction) and the length of the inner gate spacer 210 in the first direction (D1 direction).

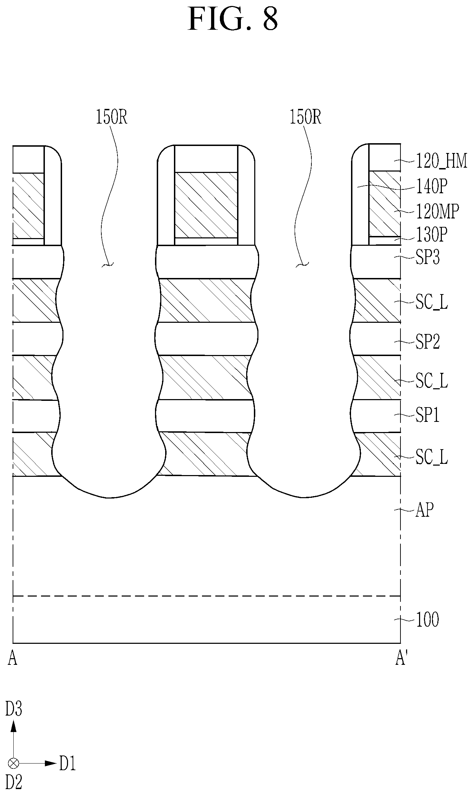

As shown in FIG. 8 described later, in a method of manufacturing the semiconductor device 10 according to an embodiment, when the source/drain recess 150R is formed, instead of etching the semiconductor layer ACT_L using an etchant having a relatively high etching rate, so that the semiconductor layer ACT_L is more etched than the sacrificial layer SC_L exposed by the source/drain recess 150R, the sacrificial layer (SC_L) is etched using an etchant having a relatively high etching rate so that the sacrificial layer (SC_L) is more etched than the semiconductor layer (ACT_L), and then as shown in FIG. 9 to be described later, an indent process for the semiconductor patterns SP1, SP2, and SP3 may be performed to further reduce the length of the semiconductor patterns SP1, SP2, and SP3 in the first direction (D1 direction) so that a surface of the inner gate spacer 210 contacting the source/drain pattern 150 may have a substantially concave or flat shape toward the source/drain pattern 150. In addition, the semiconductor patterns SP1, SP2, and SP3 may also have a concave shape with surfaces contacting the source/drain pattern 150 toward the source/drain pattern 150. Also, the distance T2 across the sub-gate portions S_GS1, S_GS2, and S_GS3 may be greater than the distance T1 across the semiconductor patterns SP1, SP2, and SP3.

Meanwhile, with reference to FIGS. 1-4, the main gate portion M_GS may be disposed on the third semiconductor pattern SP3 on the upper surface in a region intersecting the active pattern AP, and may be disposed on the field insulating layer 105 in a region not intersecting the active pattern AP.

Accordingly, the gate pattern GS may surround the channel pattern CP. For example, surfaces of the semiconductor patterns SP1, SP2, and SP3 that are not connected to the source/drain pattern 150, for example, four surfaces, may be surrounded by the gate pattern GS. That is, the sub-gate portions S_GS1, S_GS2, and S_GS3 may surround the upper and lower portions of the semiconductor patterns SP1, SP2, and SP3, and the main gate portion M_GS may surround side surfaces and upper portion of the semiconductor patterns SP1, SP2, and SP3. The term "connected" (or "connects," or like terms), as may be used herein, is broadly intended to include an electrical and/or physical connection, and may include other intervening elements.

The main gate portion M_GS may include a main gate electrode 120M, an interface insulating layer (not explicitly shown), and a gate insulating layer 132.

The main gate electrode 120M may include a metal, a metal alloy, a conductive metal nitride, a metal silicide, a doped semiconductor material, a conductive metal oxide, a conductive metal nitride, or a combination thereof.

The interface insulating layer may extend along upper surfaces of the semiconductor patterns SP1, SP2, and SP3 and the upper surface of the active pattern AP. The interface insulating layer may not extend along the side surface of the gate spacer 140 to be described later. However, the present disclosure is not limited thereto, and the interface insulating layer may extend along the side surface of the gate spacer 140.

The interface insulating layer may include, for example, silicon oxide (SiO₂). The gate insulating layer 132 may include, for example, a high dielectric constant material. The high dielectric constant material may include a material having a higher dielectric constant than silicon oxide (SiO₂), such as hafnium oxide (HfO), aluminum oxide (AIO), or tantalum oxide (TaO).

The gate insulating layer 132 may extend along the side surfaces and lower surfaces of the main gate electrode 120M. The gate insulating layer 132 may extend along the side surfaces of the gate spacer 140. Also, the gate insulating layer 132 may surround the semiconductor patterns SP1, SP2, and SP3. The gate insulating layer 132 may be disposed along the circumferences of the semiconductor patterns SP1, SP2, and SP3. The gate insulating layer 132 may be disposed between the sub-gate electrode 120 and the inner gate spacer 210.

The gate insulating layer 132 may include, for example, a high dielectric constant (high-k) material. The high dielectric constant material may include a material having a higher dielectric constant than silicon oxide (SiO₂), such as hafnium oxide (HfO), aluminum oxide (AIO), or tantalum oxide (TaO), although embodiments are not limited thereto.

The gate spacer 140 may be disposed on a side surface of the main gate electrode 120M. The gate spacer 140 may not be disposed between the active pattern AP and the semiconductor patterns SP1, SP2, and SP3. The gate spacer 140 may not be disposed between the semiconductor patterns SP1, SP2, and SP3 adjacent in the third direction (D3 direction).

The gate spacer 140 may include, for example, silicon nitride (SiN), silicon oxynitride (SiON), silicon oxide (SiO₂), silicon oxycarbonitride (SiOCN), silicon boron nitride (SiBN), silicon oxyboronitride (SiOBN), silicon oxycarbide (SiOC), or a combination thereof. Although the gate spacer 140 is illustrated as being a single layer, it is only for convenience of description and is not limited thereto; that is, the gate spacer 140 may comprise a plurality of material layers (e.g., two or more).

The capping layer 145 may be disposed on the main gate portion M_GS and the gate spacer 140. An upper surface of the capping layer 145 and an upper surface of the interlayer insulating layer 190 may be on the same plane (i.e., coplanar). Unlike the arrangement shown, the capping layer 145 may be disposed between the gate spacers 140.

The capping layer 145 may include, for example, silicon nitride (SiN), silicon nitride (SiON), silicon carbonitride (SiCN), silicon oxycarbonitride (SiOCN), or a combination thereof. The capping layer 145 may include a material having an etch selectivity with respect to the interlayer insulating layer 190.

The source/drain pattern 150 may be disposed on the active pattern AP.

The source/drain pattern 150 may be disposed in the source/drain recess 150R extending in the third direction (D3 direction). The source/drain pattern 150 may fill the source/drain recess 150R. A bottom surface of the source/drain recess 150R may be defined by the active pattern AP. Side surfaces of the source/drain recess 150R may be defined by the semiconductor patterns SP1, SP2, and SP3 and sub-gate portions S_GS1, S_GS2, and S_GS3.

The source/drain pattern 150 may be disposed on side surfaces of the sub-gate portions S_GS1, S_GS2, and S_GS3. For example, the source/drain patterns 150 may contact side surfaces of the inner gate spacers 210 of the sub-gate portions S_GS1, S_GS2, and S_GS3. The source/drain pattern 150 may be disposed between adjacent sub-gate portions S_GS1, S_GS2, and S_GS3 in the first direction (D1 direction). For example, the source/drain patterns 150 may be disposed on both sides of the sub-gate portions S_GS1, S_GS2, and S_GS3.

The source/drain pattern 150 may be disposed on side surfaces of the semiconductor patterns SP1, SP2, and SP3 of the channel pattern CP. For example, the source/drain pattern 150 may contact side surfaces of the semiconductor patterns SP1, SP2, and SP3. The source/drain pattern 150 may be disposed between semiconductor patterns SP1, SP2, and SP3 adjacent to each other in the first direction (D1 direction).

A side surface of the source/drain pattern 150, in the third direction D3, may have an uneven wavy shape. For example, side surfaces of the source/drain pattern 150 adjacent to the sub-gate portions S_GS1, S_GS2, and S_GS3 may have a convex shape toward the sub-gate portions S_GS1, S_GS2, and S_GS3, and a side surface of the source/drain pattern 150 adjacent to the semiconductor patterns SP1, SP2, and SP3 may have a convex shape toward the semiconductor patterns SP1, SP2, and SP3.

The source/drain patterns 150 may be epitaxial patterns formed by a selective epitaxial growth process using the active pattern AP as a seed. The source/drain pattern 150 may include, for example, at least one of silicon (Si) and silicon germanium (SiGe). The semiconductor patterns SP1, SP2, and SP3 may be a portion of the active pattern AP extending between the source/drain patterns 150. The source/drain pattern 150 may serve as a source/drain of a transistor using the semiconductor patterns SP1, SP2, and SP3 as a channel region.

The source/drain pattern 150 may include a first source/drain pattern 151 and a second source/drain pattern 152. The first source/drain pattern 151 may have a shape surrounding side and lower surfaces of the second source/drain pattern 152; that is, the first source/drain pattern 151 may follow a contour of the side and lower surfaces of the second source/drain pattern 152. The semiconductor patterns SP1, SP2, and SP3 may contact the first source/drain pattern 151 and may not contact the second source/drain pattern 152. Accordingly, the first source/drain pattern 151 may be disposed between the semiconductor patterns SP1, SP2, and SP3 and the second source/drain pattern 152. However, the present disclosure is not limited thereto, and at least a portion of the semiconductor patterns SP1, SP2, and SP3 may contact the second source/drain pattern 152. In addition, the source/drain pattern 150, in some embodiments, may be formed of a single layer instead of being divided into the first source/drain pattern 151 and the second source/drain pattern 152.

The source/drain pattern 150 may include, for example, SiGe. A Ge content of the first source/drain pattern 151 may be different from a Ge content of the second source/drain pattern 152. The first source/drain pattern 151 may comprise SiGe including a low concentration of Ge, and the second source/drain pattern 152 may comprise SiGe including a high concentration of Ge. However, the material of the source/drain pattern 150 is not limited thereto and may be variously changed.

Referring back to FIG. 2, the etch stop layer 185 may be disposed on a side surface of the gate spacer 140 and an upper surface of the source/drain pattern 150. The etch stop layer 185 may include a material having an etch selectivity with respect to the interlayer insulating layer 190 to be described later. The etch stop layer 185 may include, for example, silicon nitride (SiN), silicon oxynitride (SiON), silicon oxycarbonitride (SiOCN), silicon boron nitride (SiBN), silicon oxyboronitride (SiOBN), silicon oxycarbide (SiOC), or a combination thereof.

The interlayer insulating layer 190 may be disposed on the etch stop layer 185. An interlayer insulating layer 190 may be disposed on the source/drain pattern 150. The interlayer insulating layer 190 may not cover the upper surface of the capping layer 145.

The interlayer insulating layer 190 may include, for example, at least one of silicon oxide (SiO₂), silicon nitride (SiN), silicon nitride (SiON), or a low dielectric constant material. The low dielectric constant material may include, for example, fluorinated tetraethylorthosilicate (FTEOS), hydrogen silses quioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutosiloxane (DADBS), trimethylsilyl Phosphate (TMSP), polytetrafluoroethylene (PTFE), TOSZ (tonen SilaZen), FSG (fluoride silicate glass), polyimide nanofoams such as polypropylene oxide, CDO (carbon doped silicon oxide), OSG (organo silicate glass), SiLK, amorphous fluorinated carbon, silica aerogels, silica xerogels, mesoporous silica, or a combination thereof, but is not limited thereto.

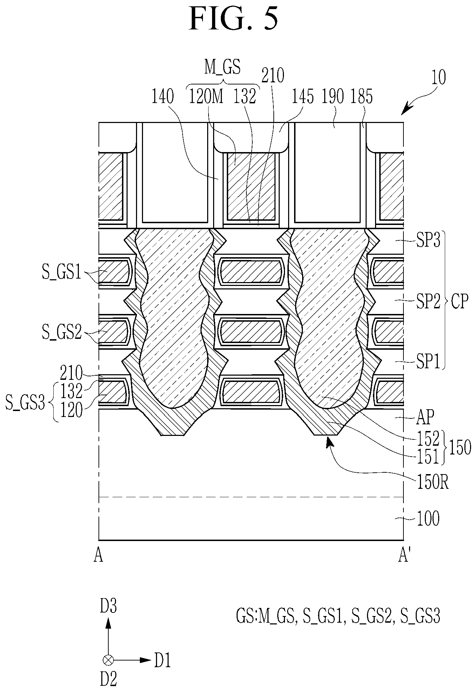

Hereinafter, a semiconductor device 10 according to an embodiment will be described with reference to FIG. 5.

FIG. 5 is a cross-sectional view corresponding to FIG. 2 showing a semiconductor device 10 according to an embodiment.

Since the embodiment shown in FIG. 5 has substantially the same parts as the embodiment shown in FIGS. 1 to 4, a description thereof will be omitted and differences will be mainly described.

FIG. 2 shows that the cross-sectional shape of the surface of the source/drain pattern 150 in contact with the active pattern AP has a deep and sharp (i.e., a pointed lowermost portion of the source/drain pattern 150) shape toward the active pattern AP, that is, in a third direction (D3 direction). However, in FIG. 5, the cross-sectional shape of the lowermost surface of the source/drain pattern 150 in contact with the active pattern AP is illustrated as having a substantially flat shape toward the active pattern AP.

As illustrated in FIG. 9 described later, in the method of manufacturing the semiconductor device 10 according to an embodiment, when sufficient etchant is used during an indent process for the semiconductor patterns SP1, SP2, and SP3, as shown in FIG. 2, the cross-sectional shape of the surface of the source/drain pattern 150 in contact with the active pattern AP has a deep and sharp (i.e., pointed) shape.

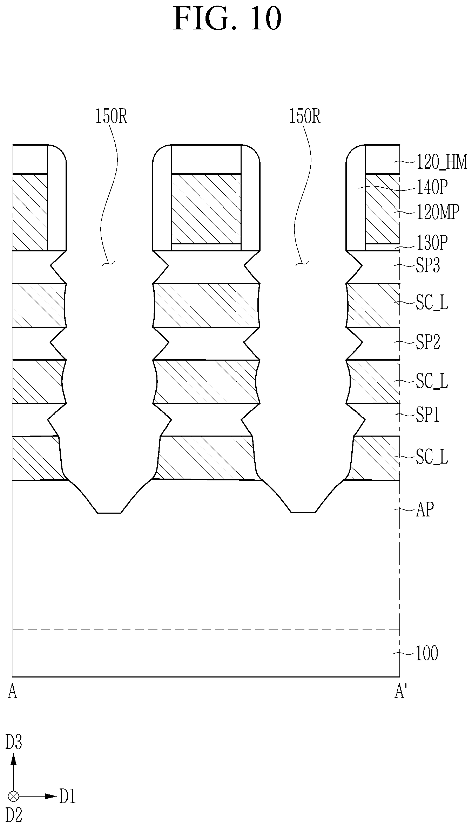

On the other hand, as shown in FIG. 10 to be described later, when sufficient etchant is not used, by stopping etching when the etchant meets the (111) plane of the active pattern AP or by using an etch stop layer, as shown in FIG. 5, the cross-sectional shape of the surface (e.g. a bottom surface) of the source/drain pattern 150 in contact with the active pattern AP is substantially flat.

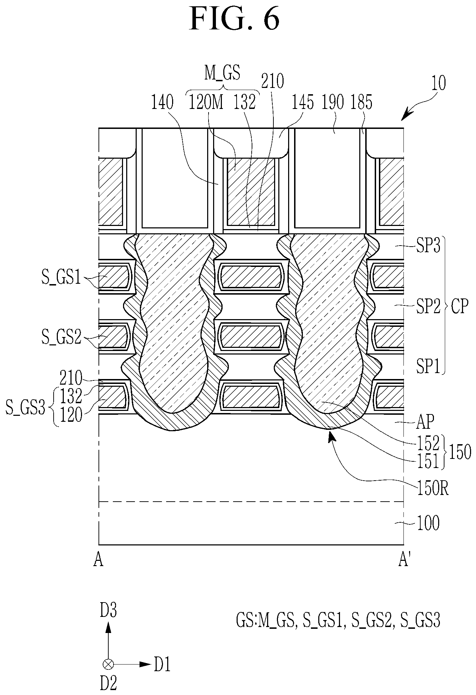

FIG. 6 is a cross-sectional view corresponding to FIG. 2 showing a semiconductor device 10 according to an embodiment.

Since the embodiment shown in FIG. 6 has substantially the same parts as the embodiment shown in FIGS. 1 to 4, a description thereof will be omitted and differences will be mainly described.

In FIG. 2, the concave cross-sectional shape of the surface of the semiconductor pattern in contact with the source/drain pattern 150 is shown as being substantially triangular in shape (i.e., portions of the sidewalls of the source/drain pattern 150 contacting the semiconductor patterns SP1, SP2, and SP3), but in FIG. 6, the concave cross-sectional shape of the surface of the semiconductor pattern in contact with the source/drain pattern 150 is shown to be semi-circular or round.

In addition, in FIG. 2, the cross-sectional shape of the surface of the source/drain pattern 150 in contact with the active pattern AP has a deep and sharp shape toward the active pattern AP, that is, in a third direction (D3 direction) (i.e., a pointed lowermost portion of the source/drain pattern 150). However, in FIG. 6, the cross-sectional shape of the lowermost surface of the source/drain pattern 150 in contact with the active pattern AP is illustrated as having a substantially round shape toward the active pattern AP.

As illustrated in FIG. 9 described later, in the method of manufacturing the semiconductor device 10 according to an embodiment, when a wet etching method is used in an indent process for the semiconductor patterns SP1, SP2, and SP3, as shown in FIG. 2, the concave cross-sectional shape of a surface of the semiconductor patterns SP1, SP2, and SP3 in contact with the source/drain pattern 150 may be a triangle, and the cross-sectional shape of the surface of the source/drain pattern 150 in contact with the active pattern AP may have a deep and sharp shape toward the active pattern AP.

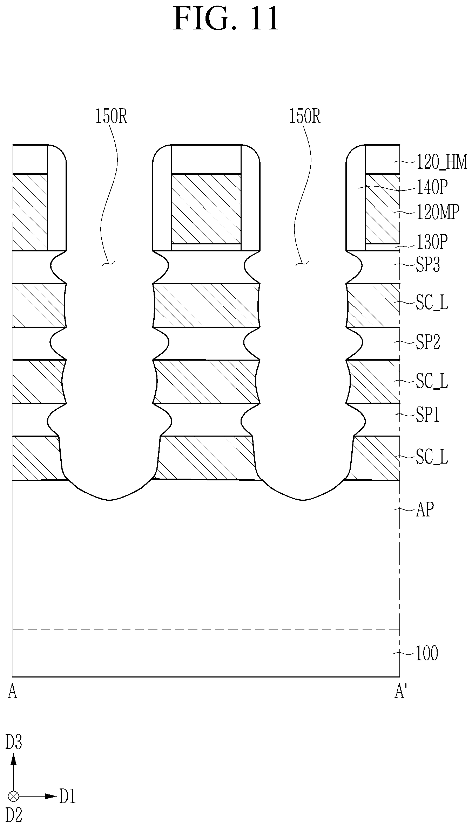

Meanwhile, as shown in FIG. 11 described later, when the dry etching method is used, as shown in FIG. 6, the concave cross-sectional shape of a surface of the semiconductor patterns SP1, SP2, and SP3 in contact with the source/drain pattern 150 may be semi-circular or round, and the cross-sectional shape of the surface of the source/drain pattern 150 in contact with the active pattern AP may have a substantially round shape toward the active pattern AP.

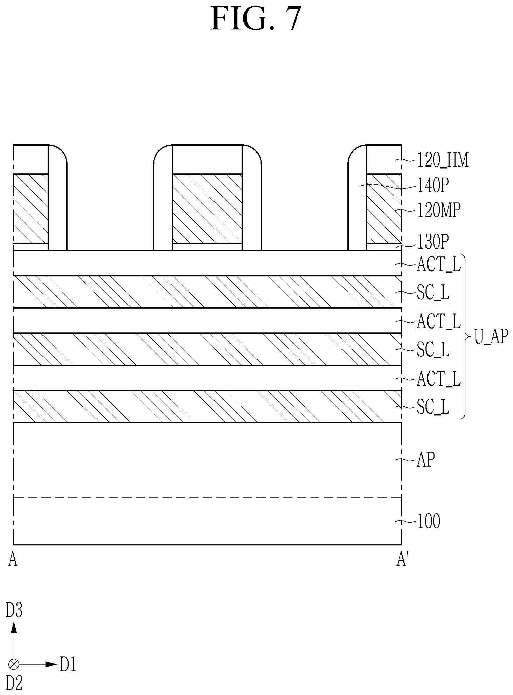

Hereinafter, a method of manufacturing the semiconductor device 10 according to an embodiment will be described with reference to FIGS. 7 to 16.

FIGS. 7 to 9 and 12 to 16 are cross-sectional views illustrating intermediate stages of an example method of manufacturing a semiconductor device 10, taken along line A-A' of FIG. 1, according to embodiments. FIGS. 10 and 11 are cross-sectional views corresponding to FIG. 9 illustrating alternative intermediate steps of an example method of manufacturing a semiconductor device 10, taken along line A-A' of FIG. 1, according to embodiments.

As shown in FIG. 7, an active pattern AP and an upper pattern U_AP are formed on the substrate 100.

The upper pattern U_AP may be disposed on the active pattern AP. The upper pattern U_AP may include sacrificial layers SC_L and semiconductor layers ACT_L alternately stacked on the active pattern AP in the third direction D3. For example, the sacrificial layers SC_L may include silicon germanium (SiGe), and the semiconductor layers ACT_L may include silicon (Si).

Subsequently, a preliminary gate insulating layer 130P, a preliminary main gate electrode 120MP, and a preliminary capping layer 120_HM are formed on the upper pattern U_AP. The preliminary gate insulating layer 130P may include, for example, silicon oxide, but is not limited thereto. The preliminary main gate electrode 120MP may include, for example, polysilicon, but is not limited thereto. The preliminary capping layer 120_HM may include, for example, silicon nitride, but is not limited thereto.

Preliminary gate spacers 140P may be formed on both side surfaces of the preliminary main gate electrode 120MP.

As shown in FIG. 8, at least a portion of the upper pattern U_AP may be etched using the preliminary main gate electrode 120MP and the preliminary gate spacer 140P as a mask to form source/drain recesses 150R. A portion of each source/drain recess 150R may be formed in the active pattern AP; that is, the source/drain recess 150R may extend, in the third direction D3 toward the substrate 100, through the upper pattern U_AP and partially into the active pattern AP.

As the source/drain recesses 150R are formed, the semiconductor layers ACT_L are separated to form semiconductor patterns SP1, SP2, and SP3. The semiconductor patterns SP1, SP2, and SP3 are formed between the source/drain recesses 150R. The semiconductor patterns SP1, SP2, and SP3 and the sacrificial layers SC_L may be alternately stacked in the third direction (D3 direction). In this case, the lengths of each of the semiconductor patterns SP1, SP2, and SP3 may be different or the same.

In the process of forming the source/drain recesses 150R by etching at least a portion of the upper patterns U_AP, the etching process may be performed using an etchant having a relatively high etching rate for the sacrificial layers SC_L. That is, the etching process may use an etchant that has a higher etching rate for the sacrificial layers SC_L than for the semiconductor layers ACT_L. For example, when the sacrificial layers SC_L include silicon germanium (SiGe) and the semiconductor patterns SP1, SP2, and SP3 include silicon (Si), the etching process may be performed using an etchant having a relatively high etching rate for silicon germanium (SiGe) (e.g. relative to the etching rate for silicon).

Accordingly, the semiconductor patterns SP1, SP2, and SP3 exposed by the source/drain recesses 150R are less etched than the sacrificial layers SC_L exposed by the source/drain recesses 150R, the semiconductor patterns SP1, SP2, and SP3 may protrude toward the source/drain recesses 150R, and the sacrificial layers SC_L may have a concave shape toward (e.g. facing toward) the source/drain recesses 150R.

As shown in FIG. 9, an indent process may be performed on the semiconductor patterns SP1, SP2, and SP3.

In the indent process, lengths of the semiconductor patterns SP1, SP2, and SP3 in the first direction (D1 direction) are further reduced by etching the semiconductor patterns SP1, SP2, and SP3 using a wet etching or dry etching method.

Accordingly, surfaces of the semiconductor patterns SP1, SP2, and SP3 that are in contact with the source/drain pattern 150 may also have a concave shape toward (e.g. facing toward) the source/drain pattern 150.

For example, when using a wet etching method, an etching solution such as ammonia water may be used.

When sufficient etchant is used during the indent process of the semiconductor patterns SP1, SP2, and SP3, as shown in FIG. 9, the cross-sectional shape of the surface of the source/drain pattern 150 in contact with the active pattern AP (i.e., lowermost surface of the source/drain recess 150R) has a deep and sharp shape, and if sufficient etching solution is not used, by stopping etching when the etchant meets the (111) plane of the active pattern AP or by using an etch stop layer, as shown in FIG. 10, the cross-sectional shape of the surface of the source/drain pattern 150 in contact with the active pattern AP (i.e., lowermost surface of the source/drain recess 150R) is substantially flat.

In addition, when a wet etching method is used in an indent process for the semiconductor patterns SP1, SP2, and SP3, as shown in FIG. 9, the concave cross-sectional shape of a surface of the semiconductor patterns SP1, SP2, and SP3 in contact with the source/drain pattern 150 may be triangular, and the cross-sectional shape of the surface of the source/drain pattern 150 in contact with the active pattern AP may have a deep and sharp shape toward the active pattern AP (as shown in FIG. 9), but when the dry etching method is used, as shown in FIG. 11, the concave cross-sectional shape of a surface of the semiconductor patterns SP1, SP2, and SP3 in contact with the source/drain pattern 150 may be semi-circular or round, and the cross-sectional shape of the surface of the source/drain pattern 150 in contact with the active pattern AP may have a substantially round shape toward the active pattern AP.

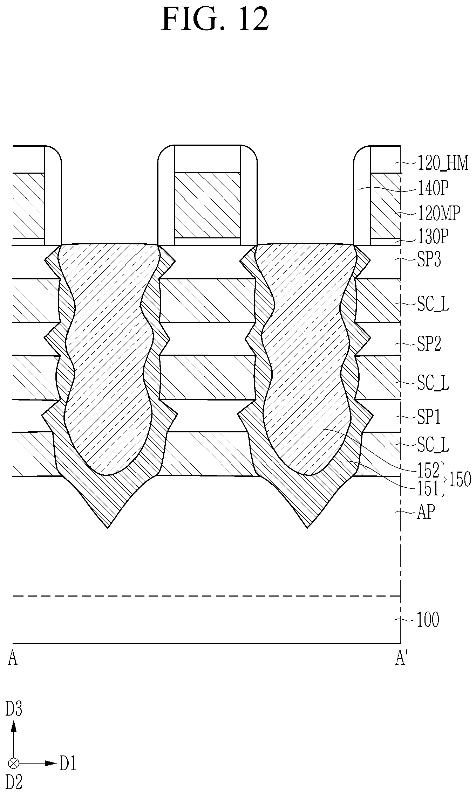

As shown in FIG. 12, a source/drain pattern 150 is formed in each of the source/drain recesses 150R.

Each source/drain pattern 150 may be formed using an epitaxial growth method. In this case, an inner wall of the source/drain recess 150R may be used as a seed layer. The inner wall of the source/drain recess 150R may be defined by semiconductor patterns SP1, SP2, and SP3, a side surface of the sacrificial layer SC_L, and an upper surface of the active pattern AP.

Each source/drain pattern 150 may include a first source/drain pattern 151 and a second source/drain pattern 152. The second source/drain pattern 152 may have a higher doping concentration than the first source/drain pattern 151. First, after forming the first source/drain pattern 151 in the source/drain recess 150R, the second source/drain pattern 152 may be formed on the first source/drain pattern 151. The first source/drain pattern 151 may directly contact the semiconductor patterns SP1, SP2, and SP3, the sacrificial layers SC_L, and the active pattern AP. The second source/drain pattern 152 may not directly contact the semiconductor patterns SP1, SP2, and SP3, the sacrificial layers SC_L, and the active pattern AP. The first source/drain pattern 151 may be disposed between the second source/drain pattern 152 and the semiconductor patterns SP1, SP2, and SP3. The first source/drain pattern 151 may be disposed between the second source/drain pattern 152 and the sacrificial layers SC_L. The first source/drain pattern 151 may be disposed between the second source/drain pattern 152 and the active pattern AP.

The source/drain pattern 150 may include SiGe. A Ge content of the first source/drain pattern 151 may be different from a Ge content of the second source/drain pattern 152. The first source/drain pattern 151 may be made of SiGe including a low concentration of Ge, and the second source/drain pattern 152 may be made of SiGe including a high concentration of Ge. The Ge content of the first source/drain pattern 151 may be lower than the Ge content of the second source/drain pattern 152. A difference between the Ge content of the first source/drain pattern 151 and the Ge content of the second source/drain pattern 152 may be greater than or equal to about 20% (e.g. greater than or equal to 20%). However, the material of the source/drain pattern 150 is not limited thereto and may be variously changed.

As described above, by further reducing the lengths of the semiconductor patterns SP1, SP2, and SP3 in the first direction (D1 direction) in the indent process, the second source/drain pattern 152 having a high doping concentration is closer to the sides of the semiconductor patterns SP1, SP2, and SP3 than to the sides of the sub-gate portions S_GS1, S_GS2, S_GS3 to improve a channel resistance and to ensure a uniform work function.

In addition, the inner gate spacers 210 (FIG. 2) are not formed when the source/drain patterns 150 are formed, but the inner gate spacers 210 are formed after the sacrificial layers SC_L are removed and before the sub-gate electrodes 120 are formed. In this manner, leakage current may be reduced by the inner gate spacer 210 while improving distribution during epitaxial formation of the source/drain pattern 150.

Next, as shown in FIG. 13, an etch stop layer 185 and an interlayer insulating layer 190 are sequentially formed on the source/drain pattern 150.

Subsequently, a portion of the interlayer insulating layer 190, a portion of the etch stop layer 185, and the preliminary capping layer 120_HM (FIG. 12) are removed to expose an upper surface of the preliminary main gate electrode 120MP. While the upper surface of the preliminary main gate electrode 120MP is exposed, the gate spacer 140 may be formed.

As shown in FIG. 14, the exposed preliminary main gate electrode 120MP is removed using an etching process. As the preliminary main gate electrode 120MP is removed, the sacrificial layers SC_L may be exposed to the outside, and the sacrificial layers SC_L may also be removed.

The sacrificial layers SC_L and the preliminary main gate electrode 120MP may comprise a material having a high selectivity with respect to the semiconductor patterns SP1, SP2, and SP3 and the source/drain pattern 150. For example, the sacrificial layers SC_L and the preliminary main gate electrode 120MP may comprise silicon oxide, the semiconductor patterns SP1, SP2, and SP3 may comprise Si, and the source/drain pattern 150 may comprise SiGe. The etching process may be performed using an etchant having a relatively high etching rate for silicon oxide (e.g. relative to the etching rate for silicon). Accordingly, the etching process is configured such that the preliminary main gate electrode 120MP and the sacrificial layers SC_L are removed (thereby forming gate trenches 120t), and the semiconductor patterns SP1, SP2, and SP3 and the source/drain pattern 150 remain.

As shown in FIG. 15, inner gate spacers 210 are formed in spaces (i.e., gate trenches 120t) where the sacrificial layers SC_L are removed.

Each inner gate spacer 210 may be formed on a surface exposed by a space from which a sacrificial layer SC_L is removed. The inner gate spacers 210 may be disposed on exposed surfaces of the semiconductor patterns SP1, SP2, and SP3. In addition, the inner gate spacers 210 may be disposed on the exposed surfaces of the source/drain patterns 150. Accordingly, a surface where the inner gate spacer 210 is in contact with the sub-gate electrode 120 may have a substantially concave or flat shape toward (e.g. facing toward) the sub-gate electrode 120, and a surface where the inner gate spacer 210 is in contact with the source/drain pattern 150 may have a substantially concave or flat shape toward (e.g. facing toward) the source/drain pattern 150.

The inner gate spacers 210 may be formed using, for example, an atomic layer deposition (ALD) process, a chemical vapor deposition (CVD) process, or a physical vapor deposition (PVD) process, although embodiments are not limited thereto.

The inner gate spacers 210 may include a low dielectric constant material. The low dielectric constant material may include silicon oxide or a material having a lower dielectric constant than silicon oxide. For example, in some embodiments the low dielectric constant material may include silicon oxide, silicon oxide doped with fluorine or carbon, porous silicon oxide, an organic polymeric dielectric, or a combination thereof.

Optionally, as shown in FIG. 16, a thickness of each of the inner gate spacers 210 may be reduced through an etching process. Through this etching process, a sufficient space (e.g., gate trench 120t) in which the sub-gate electrode 120 (see FIG. 2) is formed may be secured. Accordingly, as described above, the thickness of the first portion 211 of the inner gate spacer 210 may be greater than the thickness of the second portion 212 of the inner gate spacer 210.

Next, as shown in FIG. 2, a gate insulating layer 132 is formed in the space where the preliminary main gate electrode 120MP and the sacrificial layers SC_L were removed, and the main gate electrode 120M and the sub-gate electrodes 120 are formed on the gate insulating film 132. In this case, an inner gate spacer 210 is formed in a space where the sacrificial layers SC_L were removed, and a gate insulating layer 132 is formed on the inner gate spacer 210.

The gate insulating layer 132 may be formed, for example, using an atomic layer deposition (ALD) process, a chemical vapor deposition (CVD) process, or a physical vapor deposition (PVD) process. The gate insulating layer 132 may include oxide, nitride, or a high dielectric constant (high-k) material. The gate insulating layer 132 may have a single-layer structure or a multi-layer structure made of a combination of these materials. The high dielectric constant material may have a dielectric constant between about 10 and about 25 (e.g. between 10 and 25). For example, the about may include hafnium oxide, hafnium oxynitride, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, or a combination thereof. However, these may be only examples, and the material of the gate insulating layer 132 is not limited thereto.

Subsequently, a main gate electrode 120M and sub-gate electrodes 120 are formed on the gate insulating layer 132.

The sub-gate electrodes 120 are disposed in spaces (120t) where the sacrificial layers SC_L were removed. Each sub-gate electrode 120 is disposed on the gate insulating layer 132 and is formed to fill the corresponding space.

The main gate electrode 120M is disposed in a space where the preliminary main gate electrode 120MP is removed. The main gate electrode 120M is disposed on the gate insulating layer 132 and is formed to fill the space. The gate insulating layer 132 may be disposed between the main gate electrode 120M and the gate spacer 140.

The gate pattern GS may be formed using an atomic layer deposition (ALD) process, a chemical vapor deposition (CVD) process, or the like. The gate pattern GS may include doped polysilicon, a metal, conductive metal nitride, conductive metal carbide, or a combination thereof. However, these may be only examples, and the material of the gate pattern GS is not limited thereto.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

### <Description of symbols>

10: semiconductor device
100: substrate
105: field insulating layer
AP: active pattern
CP: channel pattern
SP1, SP2, SP3: semiconductor pattern
GS: gate pattern
M_GS: main gate portion
S_GS1, S_GS2, S_GS3: sub-gate portion
120M: main gate electrode
120: sub-gate electrode
132: gate insulating layer
140: gate spacer
145: capping layer
150: source/drain pattern
151: first source/drain pattern
152: first source/drain pattern
150R: source/drain recess
210: inner gate spacer
211: first portion
212: second portion
185: etch stop layer
190: interlayer insulating layer
U_AP: upper pattern (upper pattern structure)
SC_L: sacrificial layer
ACT_L: semiconductor layer
120MP: preliminary main gate electrode
120_HM: preliminary capping layer
130P: preliminary gate insulating layer
140P: preliminary gate spacer
150R: source/drain recess

### <Clauses>

Embodiments are set out in the following clauses:
1. A semiconductor device, comprising:
   an active pattern on a substrate;
   a plurality of source/drain patterns on the active pattern;
   a channel pattern electrically connecting the source/drain patterns and including stacked semiconductor patterns spaced apart from each other in a first direction perpendicular to an upper surface of the substrate;
   a gate pattern crossing between the source/drain patterns in a second direction parallel to the upper surface of the substrate, on the channel pattern, and having a main gate portion and sub-gate portions; and
   inner gate spacers having a first portion between the sub-gate portions and the source/drain patterns, and a second portion between the sub-gate portions and the semiconductor patterns;
   wherein a first distance between adjacent source/drain patterns of the plurality of source/drain patterns along a given one of the sub-gate portions in the second direction is greater than a second distance between the adjacent source/drain patterns along a given one of the semiconductor patterns in the second direction.
2. The semiconductor device of clause 1, wherein
   the given one of the sub-gate portions and the given one of the semiconductor patterns are adjacent to each other.
3. The semiconductor device of clause 1 or clause 2, wherein
   a surface where each of the semiconductor patterns is in contact with a corresponding one of the source/drain patterns has a concave cross-sectional shape toward the source/drain patterns.
4. The semiconductor device of clause 3, wherein
   the concave cross-sectional shape of the surface is a semicircle, a semiellipse, a triangle, a quadrangle, a polygon, or a combination thereof.
5. The semiconductor device of any preceding clause, wherein
   a cross-sectional shape of a surface where each of the source/drain patterns is in contact with the active pattern has a pointed shape, a round shape, or a flat shape toward the active pattern.
6. The semiconductor device of any preceding clause, wherein
   a surface where each of the inner gate spacers are in contact with the source/drain patterns has a concave or flat cross-sectional shape toward the source/drain patterns.
7. The semiconductor device of any preceding clause, wherein
   the first portion and the second portion of each of the inner gate spacers are connected to each other and extend around the sub-gate portions.
8. The semiconductor device of any preceding clause, wherein
   a first thickness of the first portion, the first thickness being a distance in the second direction between a given one of the sub-gate portions and a given one of the source/drain patterns, is greater than
   a second thickness of the second portion, the second thickness being a distance in the first direction between a given one of the sub-gate portions and the semiconductor pattern.
9. The semiconductor device of clause 8, wherein
   a ratio of the first thickness to the second thickness is less than about 1:1.
10. The semiconductor device of any preceding clause, wherein
   the gate pattern further includes a gate insulating layer between each of the sub-gate portions and a corresponding one of the inner gate spacers.
11. The semiconductor device of any preceding clause, wherein
   a surface where each of the inner gate spacers is in contact with a corresponding one of the source/drain patterns has a concave or flat shape toward the source/drain patterns, and
   a surface where each of the semiconductor patterns is in contact with a corresponding one of the source/drain patterns has a concave cross-sectional shape toward the source/drain patterns.
12. The semiconductor device of clause 11, wherein
   the given one of the sub-gate portions and the given one of the semiconductor patterns are adjacent to each other.
13. The semiconductor device of clause 11 or clause 12, wherein
   a surface where each of the inner gate spacers is in contact with a corresponding one of the sub-gate portions has a concave or flat cross-sectional shape toward the sub-gate portions.
14. The semiconductor device of any of clauses 11-13, wherein
   the concave cross-sectional shape of the surface is a semicircle, a semiellipse, a triangle, a quadrangle, a polygon, or a combination thereof.
15. The semiconductor device of any of clauses 11-14, wherein
   the gate pattern further includes a gate insulating layer between the sub-gate portions and the inner gate spacers.

## Claims

1. A semiconductor device, comprising:
an active pattern on a substrate;
a plurality of source/drain patterns on the active pattern;
a channel pattern electrically connecting the source/drain patterns and including stacked semiconductor patterns spaced apart from each other in a first direction perpendicular to an upper surface of the substrate;
a gate pattern crossing between the source/drain patterns in a second direction parallel to the upper surface of the substrate, on the channel pattern, and having a main gate portion and sub-gate portions; and
inner gate spacers having a first portion between the sub-gate portions and the source/drain patterns, and a second portion between the sub-gate portions and the semiconductor patterns;
wherein a first distance between adjacent source/drain patterns of the plurality of source/drain patterns along a given one of the sub-gate portions in the second direction is greater than a second distance between the adjacent source/drain patterns along a given one of the semiconductor patterns in the second direction.

2. The semiconductor device of claim 1, wherein
the given one of the sub-gate portions and the given one of the semiconductor patterns are adjacent to each other.

3. The semiconductor device of claim 1 or claim 2, wherein
a surface of each of the semiconductor patterns, where the semiconductor pattern is in contact with a corresponding one of the source/drain patterns, has a concave cross-sectional shape toward the corresponding source/drain pattern.

4. The semiconductor device of claim 3, wherein
the concave cross-sectional shape of the surface of each the semiconductor patterns is a semicircle, a semiellipse, a triangle, a quadrangle, a polygon, or a combination thereof.

5. The semiconductor device of any preceding claim, wherein
a cross-sectional shape of a surface of each of the source/drain patterns, where the source/drain pattern is in contact with the active pattern, has a pointed shape, a round shape, or a flat shape toward the active pattern.

6. The semiconductor device of any preceding claim, wherein
a surface of each of the inner gate spacers, where the inner gate spacer is in contact with a corresponding one of the source/drain patterns, has a concave or flat cross-sectional shape toward the corresponding source/drain pattern.

7. The semiconductor device of any preceding claim, wherein
the first portion and the second portion of each of the inner gate spacers are connected to each other and extend around the sub-gate portions.

8. The semiconductor device of any preceding claim, wherein
a first thickness of the first portion, the first thickness being a distance in the second direction between a given one of the sub-gate portions and a given one of the source/drain patterns, is greater than
a second thickness of the second portion, the second thickness being a distance in the first direction between a given one of the sub-gate portions and the semiconductor pattern.

9. The semiconductor device of claim 8, wherein
a ratio of the first thickness to the second thickness is less than about 1:1.

10. The semiconductor device of any preceding claim, wherein
the gate pattern further includes a gate insulating layer between each of the sub-gate portions and a corresponding one of the inner gate spacers.

11. The semiconductor device of any preceding claim, wherein
a surface of each of the inner gate spacers, where the inner gate spacer is in contact with a corresponding one of the source/drain patterns, has a concave or flat shape toward the corresponding source/drain pattern, and
a surface of each of the inner gate spacers, where the semiconductor patterns is in contact with the corresponding one of the source/drain patterns, has a concave cross-sectional shape toward the corresponding source/drain pattern.

12. The semiconductor device of claim 11, wherein
a surface of each of the inner gate spaces, where the inner gate spacer is in contact with a corresponding one of the sub-gate portions, has a concave or flat cross-sectional shape toward the corresponding sub-gate portion.

13. The semiconductor device of claim 11 or claim 12, wherein
the concave cross-sectional shape of the surface of each of the inner gate spaces is a semicircle, a semiellipse, a triangle, a quadrangle, a polygon, or a combination thereof.

## Amended claims

### Amended claims in accordance with Rule 137(2) EPC.

1. A semiconductor device (10), comprising:
an active pattern (AP) on a substrate (100);
a plurality of source/drain patterns (150) on the active pattern (AP);
a channel pattern (CP) electrically connecting the source/drain patterns (150) and including stacked semiconductor patterns (SP1, SP2, SP3) spaced apart from each other in a first direction (D3) perpendicular to an upper surface of the substrate (100);
a gate pattern (GS) crossing between the source/drain patterns (150) in a second direction (D1) parallel to the upper surface of the substrate (100), on the channel pattern (CP), and having a main gate portion (M_GS) and sub-gate portions (S_GS1, S_GS2, S_GS3); and
inner gate spacers (210) having a first portion (211) between the sub-gate portions (S_GS1, S_GS2, S_GS3) and the source/drain patterns (150), and a second portion (212) between the sub-gate portions (S_GS1, S_GS2, S_GS3) and the semiconductor patterns (SP1, SP2, SP3);
wherein a first distance (T2) between adjacent source/drain patterns (150) of the plurality of source/drain patterns (150) along a given one of the sub-gate portions (S_GS1, S_GS2, S_GS3) in the second direction (D1) is greater than a second distance (T1) between the adjacent source/drain patterns (150) along a given one of the semiconductor patterns (SP1, SP2, SP3) in the second direction;
wherein
a surface of each of the inner gate spacers (210), where the inner gate spacer (210) is in contact with a corresponding one of the source/drain patterns (150), has a concave shape toward the corresponding source/drain pattern (150), and
a surface of each of the inner gate spacers (210), where the inner gate spacer (210) is in contact with a corresponding one of the sub-gate portions (S_GS1, S_GS2, S_GS3), has a concave cross-sectional shape toward the corresponding sub-gate portion (S_GS1, S_GS2, S_GS3).

2. The semiconductor device (10) of claim 1, wherein
the given one of the sub-gate portions (S_GS1, S_GS2, S_GS3) and the given one of the semiconductor patterns (SP1, SP2, SP3) are adjacent to each other.

3. The semiconductor device (10) of claim 1 or claim 2, wherein
a surface of each of the semiconductor patterns (SP1, SP2, SP3), where the semiconductor pattern (SP1, SP2, SP3) is in contact with a corresponding one of the source/drain patterns (150), has a concave cross-sectional shape toward the corresponding source/drain pattern (150).

4. The semiconductor device (10) of claim 3, wherein the concave cross-sectional shape of the surface of each the semiconductor patterns (150) is a semicircle, a semiellipse, a triangle, a quadrangle, a polygon, or a combination thereof.

5. The semiconductor device (10) of any preceding claim, wherein
a cross-sectional shape of a surface of each of the source/drain patterns (150), where the source/drain pattern (150) is in contact with the active pattern (AP), has a pointed shape, a round shape, or a flat shape toward the active pattern (AP).

6. The semiconductor device (10) of any preceding claim, wherein
the first portion (211) and the second portion (212) of each of the inner gate spacers (210) are connected to each other and extend around the sub-gate portions (S_GS1, S_GS2, S_GS3).

7. The semiconductor device (10) of any preceding claim, wherein
a first thickness (T3) of the first portion (211), the first thickness (T3) being a distance in the second direction (D1) between a given one of the sub-gate portions (S_GS1, S_GS2, S_GS3) and a given one of the source/drain patterns (150), is greater than
a second thickness (T4) of the second portion (212), the second thickness (T4) being a distance in the first direction (D3) between a given one of the sub-gate portions (S_GS1, S_GS2, S_GS3) and the semiconductor pattern (SP1, SP2, SP3).

8. The semiconductor device (10) of claim 7, wherein
a ratio of the first thickness (T3) to the second thickness (T4) is less than about 1:1.

9. The semiconductor device (10) of any preceding claim, wherein
the gate pattern (GS) further includes a gate insulating layer (132) between each of the sub-gate portions (S_GS1, S_GS2, S_GS3) and a corresponding one of the inner gate spacers (210).

10. The semiconductor device (10) of any preceding claim, wherein
a surface of each of the semiconductor patterns (SP1, SP2, SP3), where the semiconductor patterns (SP1, SP2, SP3) is in contact with the corresponding one of the source/drain patterns (150), has a concave cross-sectional shape toward the corresponding source/drain pattern (150).

11. The semiconductor device (10) of claim 10, wherein
the concave cross-sectional shape of the surface of each of the inner gate spacers is a semicircle, a semiellipse, a triangle, a quadrangle, a polygon, or a combination thereof.

12. The semiconductor device (10) of claim 1, wherein
the source/drain pattern (150) includes a first source/drain pattern (151) and a second source/drain pattern (152), and the first source/drain pattern (151) has a shape surrounding side and lower surfaces of the second source/drain pattern (152), and
wherein a side surface of the source/drain pattern (150) adjacent to the semiconductor patterns (SP1, SP2, SP3) has a convex shape toward the semiconductor patterns (SP1, SP2, SP3).

13. The semiconductor device (10) of claim 1, wherein
the source/drain pattern (150) includes a first source/drain pattern (151) and a second source/drain pattern (152), and the first source/drain pattern (151) has a shape surrounding side and lower surfaces of the second source/drain pattern (152), and
wherein a side surface of the source/drain pattern (150) has an uneven wavy shape.
